# EUROPEAN PATENT APPLICATION

(11) **EP 4 280 834 A1**
(43) Date of publication of application: **22.11.2023**
(21) Application number: 23172362.8
(22) Date of filing: 09.05.2023
(51) Int. Cl.: H05K 7/20

(54) **FLUID-COOLED ELECTRICAL COMPONENT**

(30) Priority: 17.05.2022 US 202217746759
(71) Applicant: Hamilton Sundstrand Corporation, Charlotte, NC 28217-4578 (US)
(72) Inventor: SHEPARD, Charles, DeKalb, 60115 (US)
(74) Representative: Dehns

(57) **Abstract**

A fluid-cooled electrical component includes a housing (130) having a bottom wall (132), an outer wall (134) extending from a first surface of the bottom wall (132), an inner wall (136) extending from the first surface of the bottom wall (132), the outer and inner walls (134, 136) forming a first cavity (135) therebetween, and the inner wall (136) forming a second cavity (137) therewithin, and one or more fluid channels (138) formed in the inner wall (136) of the housing, adapted and configured to pass a cooling fluid therethrough. The fluid-cooled electrical component also includes a first electrical component (110) disposed in the first cavity (135), and a second electrical component (120) disposed in the second cavity (137), both the first and second electrical components (110, 120) being adapted and configured to expel heat through the housing (130), into the cooling fluid.

## Description

### BACKGROUND OF THE INVENTION

The present invention relates to packaging of circuit components, particularly circuit components that generate substantial amounts of heat, such as those used in high power applications.

Recent technological advances allow for fluid cooling of circuit components, such as those described in U.S. Pat. No. 10,892,082 to Metzler et al., and U.S. Pat. Pub. No. 2020/0135378 to Joshi, et al.

Applicant recognizes that additional benefits of fluid cooling can be gained beyond those of the prior art by integrating multiple circuit elements together in a single fluid-cooled package. The devices, systems and related methods of the present disclosure provide advantageous solutions in this regard.

### SUMMARY OF THE INVENTION

In accordance with the present invention, devices, systems and methods are provided that integrate multiple electrical circuit components into a unitary housing with fluid cooling in order to keep the components within a preferred range of operating temperature.

In accordance with one aspect, a fluid-cooled electrical component is provided that includes a housing having a bottom wall, an outer wall extending from a first surface of the bottom wall, an inner wall extending from the first surface of the bottom wall with the outer and inner walls forming a first cavity therebetween, and the inner wall forming a second cavity therewithin, and one or more fluid channels formed in the inner wall of the housing, adapted and configured to pass a cooling fluid therethrough. The electrical component also includes a first electrical component disposed in the first cavity, and a second electrical component disposed in the second cavity, both the first and second electrical components being adapted and configured to expel heat through the housing, into the cooling fluid.

The one or more fluid channels can extend through the bottom wall and into the inner wall. The fluid-cooled electrical component can also include a transfer plate in thermal and fluid communication with a second surface of the bottom wall of the housing, adapted and configured to provide cooling fluid to the housing and remove heat from the housing.

The first electrical component can be an inductor. The inductor can be substantially toroidal in shape. The second electrical component can be a capacitor. The capacitor can be a film wound capacitor. The inner wall can be substantially annular. The fluid channels formed in the inner wall can be disposed between the first cavity and the second cavity. The first cavity can be substantially annular in shape, and/or the second cavity can be substantially cylindrical, for example.

In accordance with another aspect of the invention, a fluid-cooled housing for electrical components is provided that has a bottom wall, an outer wall extending from a first surface of the bottom wall, an inner wall extending from the first surface of bottom wall, the outer and inner walls forming a first cavity therebetween adapted and configured to receive a first electrical component, and the inner wall forming a second cavity therewithin adapted and configured to receive a second electrical component, and one or more fluid channels formed in the housing, extending through the inner wall, adapted and configured to pass a cooling fluid therethrough.

The one or more fluid channels can extend through the bottom wall and into the inner wall. The fluid-cooled housing can also include a transfer plate in thermal and fluid communication with a second surface of the bottom wall of the housing, adapted and configured to provide cooling fluid to the housing and remove heat from the housing.

In accordance with still another aspect of the invention, a method of cooling electrical components is provided, the method including the steps of providing a housing having a bottom wall, an outer wall extending from a first surface of the bottom wall, an inner wall extending from the first surface of the bottom wall, the outer and inner walls forming a first cavity therebetween, and the inner wall forming a second cavity therewithin, and one or more fluid channels formed in the housing, extending through the bottom wall and into the inner wall, adapted and configured to pass a cooling fluid therethrough, providing a first electrical component disposed in the first cavity, providing a second electrical component disposed in the second cavity, both the first and second electrical components adapted and configured to expel heat through the housing, into the cooling fluid, providing a coolant supply for providing coolant, and passing cooling fluid through the one or more fluid channels, transferring heat from the first and second electrical components to the cooling fluid.

In accordance with still a further aspect of the invention, systems that are configured with the devices set forth above are provided, including any necessary ancillary equipment, such as fluid pumps, for example.

Any of the foregoing embodiments may further include one or more potting materials disposed at the interface of the housing and the electrical components disposed therein. Potting materials can include any suitable materials, such as epoxy potting materials.

The foregoing features and elements may be combined with other features and elements in various combinations without restriction, without departing from the spirit and scope of the invention, unless expressly indicated herein otherwise. The features and advantages of the foregoing will become more apparent from the detailed description that follows, and from the appended drawings.

### BRIEF DESCRIPTION OF THE DRAWINGS

So that those skilled in the art to which the subject disclosure appertains will readily understand how to make and use the devices, systems and methods of the subject disclosure without undue experimentation, embodiments thereof will be described in detail hereinbelow with reference to certain figures, wherein:
Figure 1 is a side cross-sectional view of a fluid-cooled electrical component in accordance with a first embodiment of the invention;
Figure 2 is a top view of a fluid-cooled electrical component in accordance with the first embodiment of the invention
Figure 3 is an isometric view of a fluid-cooled electrical component in accordance with the first embodiment of the invention;
Figure 4 is a side cross-sectional view of a fluid-cooled electrical component in accordance with a second embodiment of the invention; and
Figure 5 is a side cross-sectional view of a fluid-cooled electrical component in accordance with a third embodiment of the invention.

### DETAILED DESCRIPTION OF THE INVENTION

Reference will now be made to the drawings wherein like reference numerals identify similar structural features or aspects of the subject disclosure.

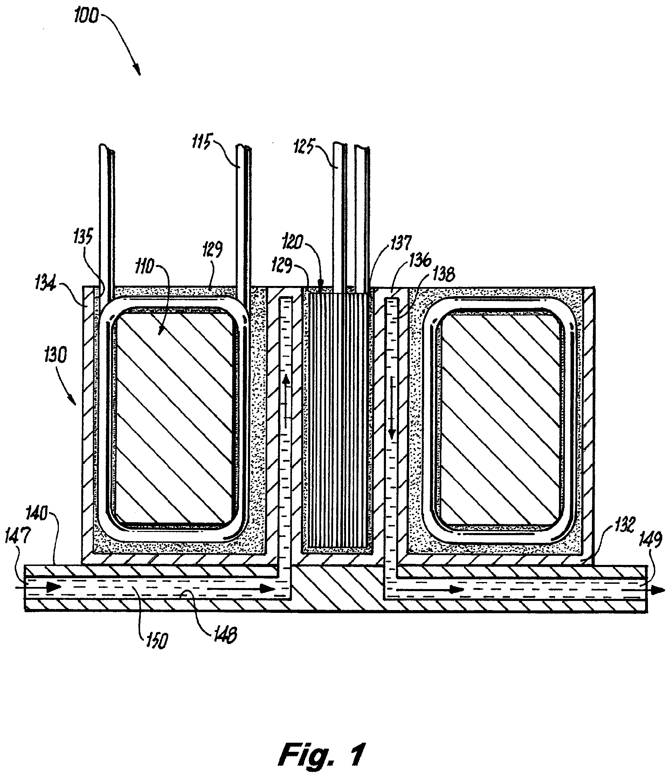

As illustrated in Figures 1-5, and in accordance with the present invention, devices, systems and methods are provided that integrate multiple electrical circuit components into a unitary housing with fluid cooling in order to keep the components within safe operating temperature ranges. In instances where circuit components are such that they can be arranged adjacently or concentrically, the path the cooling fluid takes through the housing can be configured to be between such adjacent or concentric components, thereby offering a relatively direct pathway for heat dissipation to a cooling fluid. One particularly beneficial aspect of the invention is provision for concentric arrangement of electrical components, such as a capacitor being placed within the central void of a toroidal inductor. Such an arrangement would not typically be advantageous due to the need to provide cooling of the components-usually to the surrounding air. However, by interposing a pathway for cooling fluid to circulate between such concentric components, the cooling needs are met or even exceeded for the involved components while resulting in a more compact layout of circuit components by utilizing otherwise wasted space. Moreover, by providing fluid cooling, improved cooling capacity is achieved, as compared with removal of heat by simply transferring such heat to the surrounding air. Besides allowing for a more compact design, one benefit of providing fluid cooling is that a wider range of materials can be used for components, allowing for use of materials that might otherwise be intolerant of relatively high operating temperatures. Of particular benefit is found in the cooling of capacitors. Often capacitors are a limiting factor of a circuit, with regard to operating temperature. By providing fluid cooling, the potential arises for use of a wider range of dielectric materials and films, some of which have a lower cost and/or offer increased capacitance performance, but which may be less tolerant of excessive heat, and would therefore be unsuitable for use with other cooling schemes.

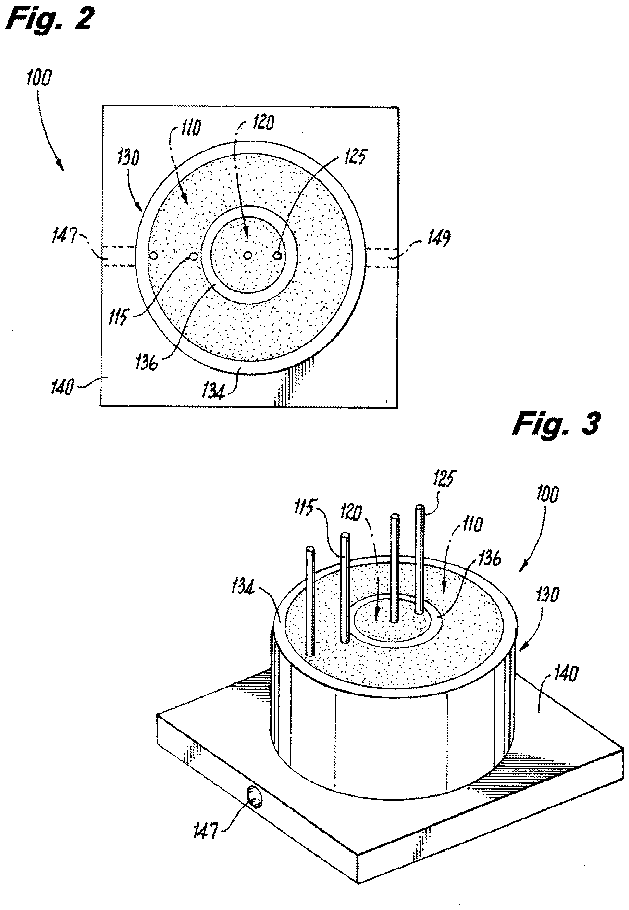

Now turning to the drawings, for purposes of explanation and illustration, and not limitation, a cross-sectional view of an exemplary embodiment of an example fluid-cooled electrical component in accordance with the present invention is shown in Figure 1 and is designated generally by reference character 100. Figures 2 and 3 illustrate top and isometric views, respectively of the fluid-cooled electrical component 100.

The fluid-cooled electrical component 100 includes a housing 130 having a bottom wall 132, an outer wall 134 extending from a first surface of the bottom wall 132, and an inner wall 136 extending from the first surface of the bottom wall 132. In conjunction with the bottom wall, 132, the outer and inner walls form a first cavity 135 therebetween, while the inner wall 136 forms a second cavity 137 therewithin. One or more fluid channels 138 are formed in the inner wall 136 of the housing 130 and are adapted and configured to pass a cooling fluid 150 therethrough. A first electrical component, in this case a toroidal inductor 110, is disposed in the first cavity 135, and a second electrical component, in this case a capacitor 120, is disposed in the second cavity 137.

The housing 130 can be formed of any suitable material, and preferably of materials having relatively high thermal conductivity. Such materials can be selected from metals, polymeric materials, ceramics or composite materials. Depending on the precise form of the fluid channel 138 through the inner wall 136, the housing 130 can be manufactured as needed. for instance, in the case of a simple fluid path, molding, casting and/or machining may be sufficient. In cases of more tortuous fluid channels 138, additive manufacturing methods may be more suitable, including but not limited to laser sintering or laser melting.

Both electrical components are adapted and configured to expel heat through the housing 130, into the cooling fluid 150. To aid in heat transfer, as well as overall stability of the device, a potting material 129 can be used to fill any space between the electrical components 110, 120 and the housing 130. As illustrated, the upper end of the housing 130, opposite the bottom wall 132 is initially open, and respective electrical components 110, 120 are inserted into the housing, with respective electrical leads 115, 125 extending away from the housing 130, and therefore accessible to subsequently make the required electrical connections.

In the embodiment illustrated in Figure 1, fluid channels 138 extend through the bottom wall 132 of the housing 130 and into the inner wall 136. A transfer plate 140 is also provided, which is in thermal and fluid communication with the lower surface of the bottom wall 132 of the housing 130. The transfer plate 140 is adapted and configured to provide cooling fluid 150 through fluid channels 148 formed therein from inlet 147 into the housing 130, in order to remove heat from the housing 130 and the devices 110, 210 held therein. The heat is removed through fluid 150 carried back through the fluid channel 148 of the transfer plate 140 to an outlet 149. Optionally, a plurality of inlets 147 and outlets 149 can be provided in order to enhance fluid flow and heat transfer characteristics.

The transfer plate 140 can be formed of any suitable material, preferably of one or more materials having relatively high thermal conductivity. Such materials can be selected from metals, polymeric materials, ceramics or composite materials, if desired.

As with the body 130, the precise form the fluid channels 148 in the transfer plate 140 take will dictate the manufacturing approach. In the case of simple linear pathways of one or two legs, as illustrated in Figure 1, simple molding, casting and/or machining processes may be sufficient. In cases of more tortuous fluid channels 148, which can be provided, for example to spread out through the body of the transfer plate 140 to enhance heat transfer, before entering the channel 138 of the inner wall 136 of the body 130, additive manufacturing methods may be more suitable. Such techniques can include but are not limited to laser sintering or laser melting, for example.

The fluid used for cooling components can vary depending on the application. The cooling fluid can be any suitable liquid such as oil, fuel, glycol, water or mixtures.

As appreciated in the cross-sectional view of Figure 1, but also in the top and isometric views of Figures 2 and 3, respectively, the toroidal or annular form of the inductor 110 advantageously provides a space for circuit elements in the central void thereof, providing the benefits of fluid cooling to both components. However, it is to be understood that other circuit elements could alternatively be provided in the spaces 135, 137 provided in the housing 130, and can thereby gain the same benefits.

As best seen in Figures 2 and 3, both the outer wall 134 and the inner wall 136 of the housing 130 are substantially annular, as is the first cavity 135, while the second cavity 137 is substantially cylindrical. Although substantially circular in section when viewed from above, it is possible to give alternate forms to the outer wall 134, inner wall 136, and therefore also to the first recess 135 and second recess 137. Alternative forms can be substantially square in section, if desired or required, without departing from the invention.

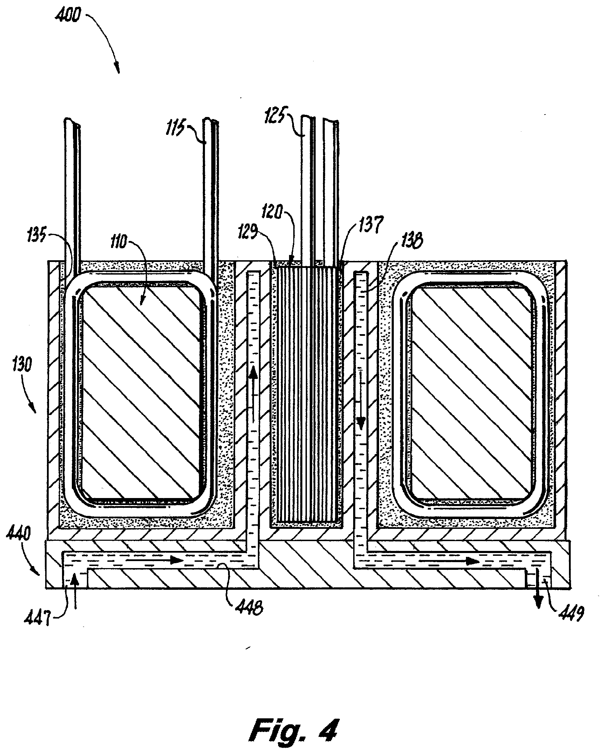

Figure 4 is a side cross-sectional view of a fluid-cooled electrical component in accordance with a second embodiment of the invention, designated generally with reference number 400. Reference numbers for elements the same as those of the embodiment of Figures 1-3 are designated with the same numbers. In accordance with this embodiment, the fluid-cooled electrical component 400 includes a transfer plate 440 with fluid inlet 447 on a lower surface thereof, rather than on the side thereof. Fluid channels 448 lead to the fluid channels 138 in the body 130, and out through fluid outlet 449. As with the foregoing embodiment, a plurality of inlets 447 and outlets 449 can be provided in order to enhance fluid flow and heat transfer characteristics.

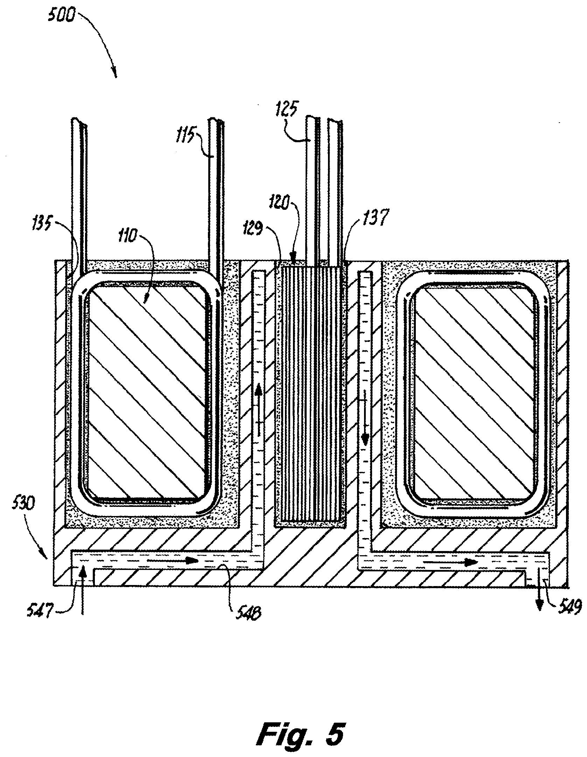

Figure 5 is a side cross-sectional view of a fluid-cooled electrical component in accordance with a third embodiment of the invention, designated generally with reference number 500. Reference numbers for elements the same as those of the embodiments of Figures 1-4 are designated with the same numbers. In accordance with this embodiment, the fluid-cooled electrical component 500 includes a body 530 that is expanded to include horizontal fluid passages 548, inlet 547 and outlet 549 provided in separate transfer plate 140/440 in the foregoing embodiments. Although illustrated with inlet(s) 547 and outlet(s) 549 on the lower surface of the body 530, it should be understood that such features can alternatively be provided in a different location. As with the foregoing embodiments, a plurality of inlets 547 and outlets 549 can be provided in order to enhance fluid flow and heat transfer characteristics. Materials used and manufacturing techniques can also be similar to the foregoing embodiments.

While the devices, systems and methods of the subject disclosure have been shown and described with reference to embodiments, those skilled in the art will readily appreciate that changes and/or modifications may be made thereto without departing from the spirit and scope of the subject disclosure.

## Claims

1. A fluid-cooled electrical component comprising:
a housing (130) having:
a bottom wall (132);
an outer wall (134) extending from a first surface of the bottom wall (132);
an inner wall (136) extending from the first surface of the bottom wall (132), the outer and inner walls (134, 136) forming a first cavity (135) therebetween, and the inner wall (136) forming a second cavity (137) therewithin; and
one or more fluid channels (138) formed in the inner wall (136) of the housing, adapted and configured to pass a cooling fluid therethrough;
a first electrical component (110) disposed in the first cavity (135); and
a second electrical component (120) disposed in the second cavity (137),
both the first and second electrical components (110, 120) adapted and configured to expel heat through the housing (130), into the cooling fluid.

2. The fluid-cooled electrical component of claim 1, wherein the one or more fluid channels (138) extend through the bottom wall (132) and into the inner wall (136).

3. The fluid-cooled electrical component of claim 1 or 2, further comprising a transfer plate (140) in thermal and fluid communication with a second surface of the bottom wall (132) of the housing, adapted and configured to provide cooling fluid to the housing (130) and remove heat from the housing (130).

4. The fluid-cooled electrical component of any preceding claim, wherein the first electrical component (110) is an inductor.

5. The fluid-cooled electrical component of claim 4, wherein the inductor is substantially toroidal in shape.

6. The fluid-cooled electrical component of any preceding claim, wherein the second electrical component (120) is a capacitor.

7. The fluid-cooled electrical component of claim 6, wherein the capacitor is a film wound capacitor.

8. The fluid-cooled electrical component of any preceding claim, wherein the inner wall (136) is substantially annular.

9. The fluid-cooled electrical component of any preceding claim, wherein the fluid channels (138) formed in the inner wall (136) are disposed between the first cavity (135) and the second cavity (137).

10. The fluid-cooled electrical component of any preceding claim, wherein the first cavity (135) is substantially annular in shape.

11. The fluid-cooled electrical component of any preceding claim, wherein the second cavity (137) is substantially cylindrical.

12. A fluid-cooled housing for electrical components having:
a bottom wall (132);
an outer wall (134) extending from a first surface of the bottom wall (132);
an inner wall (136) extending from the first surface of bottom wall (132), the outer and inner walls (134, 136) forming a first cavity (135) therebetween adapted and configured to receive a first electrical component (110), and the inner wall (136) forming a second cavity (137) therewithin adapted and configured to receive a second electrical component (120); and
one or more fluid channels (138) formed in the housing (130), extending through the inner wall (136), adapted and configured to pass a cooling fluid therethrough.

13. The fluid-cooled housing of claim 12, wherein the one or more fluid channels (138) extend through the bottom wall (132) and into the inner wall (136).

14. The fluid-cooled housing of claim 12 or 13, further comprising a transfer plate (140) in thermal and fluid communication with a second surface of the bottom wall (132) of the housing, adapted and configured to provide cooling fluid to the housing (130) and remove heat from the housing (130).

15. A method of cooling electrical components, comprising:
providing a housing having:
a bottom wall;
an outer wall extending from a first surface of the bottom wall;
an inner wall extending from the first surface of the bottom wall, the outer and inner walls forming a first cavity therebetween, and the inner wall forming a second cavity therewithin; and
one or more fluid channels formed in the housing, extending through the bottom wall and into the inner wall, adapted and configured to pass a cooling fluid therethrough;
providing a first electrical component disposed in the first cavity; and
providing a second electrical component disposed in the second cavity,
both the first and second electrical components adapted and configured to expel heat through the housing, into the cooling fluid;
providing a coolant supply for providing coolant; and
passing cooling fluid through the one or more fluid channels, transferring heat from the first and second electrical components to the cooling fluid.
